(19) Europäisches Patentamt
European Patent Office
Office européen des brevets

(11) **EP 4 142 156 A1**

(12) **EUROPEAN PATENT APPLICATION**
published in accordance with Art. 153(4) EPC

(43) Date of publication:
**01.03.2023 Bulletin 2023/09**

(21) Application number: **21809727.7**

(22) Date of filing: **13.05.2021**

(51) International Patent Classification (IPC):
**H03L 7/08** (2006.01)   **H03L 7/097** (2006.01)

(52) Cooperative Patent Classification (CPC):
**H03L 7/08; H03L 7/097**

(86) International application number:
**PCT/CN2021/093649**

(87) International publication number:
**WO 2021/233203 (25.11.2021 Gazette 2021/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.05.2020   CN 202010428524**

(71) Applicant: **ZTE Corporation**
**Shenzhen, Guangdong  518057 (CN)**

(72) Inventor: **ZHAO, Liang**
**Shenzhen, Guangdong 518057 (CN)**

(74) Representative: **Savi, Massimiliano et al**
**Notarbartolo & Gervasi S.p.A.**
**Viale Achille Papa, 30**
**20149 Milano (IT)**

(54) **PHASE DETECTION METHOD, APPARATUS THEREOF, AND DEVICE**

(57)   A phase detection method, an apparatus thereof, and a device. The phase detection apparatus comprises a signal processing assembly, a phase discrimination component, and a phase comparison assembly. The signal processing assembly is configured to obtain a reference clock signal and an initial phase value thereof. The phase discrimination component is configured to obtain a clock signal to be measured, and obtain a first phase difference signal according to the reference clock signal and the clock signal to be measured. The phase comparison assembly is configured to obtain a phase adjustment signal according to the first phase difference signal. In addition, the signal processing assembly is also configured to perform phase adjustment on the reference clock signal according to the phase adjustment signal so as to reduce the first phase difference signal, add up the adjusted phase values so as to obtain a cumulative phase value, and obtain, according to the cumulative phase value and initial phase value, the phase value of the clock signal to be measured.

Fig. 1

## Description

## CROSS-REFERENCE TO RELATED APPLICATION

This application is based on and claims the priority of Chinese patent application No. 202010428524.6 filed on May 20, 2020, the disclosure of which is incorporated herein by reference in its entirety.

## TECHNICAL FIELD

Embodiments of the present disclosure relate to, but are not limited to, the field of communications technologies, and in particular, to a phase detection method and apparatus, and a device.

## BACKGROUND

At present, 5G communication requires increasingly high accuracy of time of IEEE 1588-based clocks, for example, timing accuracy of a single node has been required within a few nanoseconds. Accuracy of a clock signal can be improved either by increasing a frequency of the clock signal or by compensating a phase of the clock signal after measurement. The former method has higher requirements on chips and processes, while the latter method has lower requirements on chips and processes. Therefore, the latter method is more competitive.

At present, there are three clock phase measurement methods widely used: the first method is to use a clock signal with a very high frequency to sample a clock signal to be measured so as to obtain phase information; the second method is to shift a phase of a clock signal to generate several clock signals with a same frequency but different phases, and then compare the clock signals with a clock signal to be measured, to find a clock signal with a phase closest to a phase of the clock signal to be measured, so as to obtain its phase information; and the third method is to shift a phase of a clock signal with a quite small step size and sample a clock signal to be measured at the same time, where after one period, phase information is obtained according to an obtained sampling value. The first method has higher requirements on chips and processes; the second method has lower implementation costs, but with lower accuracy; and the third method has higher accuracy, but a measurement speed is lower, where higher accuracy corresponds to a lower speed.

Therefore, how to complete clock phase measurement with high accuracy and high speed is an urgent technical problem to be solved.

## SUMMARY

The following is a summary of the subject matters of the present disclosure, which will be described in detail hereafter. This summary is not intended to limit the scope of protection of the claims.

Embodiments of the present disclosure provide a phase detection method and apparatus, and a device.

An embodiment in accordance with an aspect of the present disclosure provides a phase detection apparatus, including: a signal processing assembly configured to acquire a reference clock signal and an initial phase of the reference clock signal, and output the reference clock signal; a phase discrimination component connected to the signal processing assembly and configured to acquire a clock signal to be measured and obtain and output a first phase difference signal according to the reference clock signal and the clock signal to be measured; and a phase comparison assembly connected to each of the phase discrimination component and the signal processing assembly and configured to obtain and output a phase adjustment signal according to the first phase difference signal, where the signal processing assembly is further configured to perform phase adjustment on the reference clock signal according to the phase adjustment signal so as to reduce the first phase difference signal, add up the adjusted phase values so as to obtain a cumulative phase value, and obtain, according to the cumulative phase value and the initial phase, a phase of the clock signal to be measured.

An embodiment in accordance with another aspect of the present disclosure provides a phase detection method which is applied to a phase detection apparatus, where the phase detection apparatus includes a signal processing assembly, a phase discrimination component and a phase comparison assembly serially connected in a loop. The method includes: acquiring, by the signal processing assembly, a reference clock signal and an initial phase of the reference clock signal, and outputting the reference clock signal to the phase discrimination component; acquiring, by the phase discrimination component, a clock signal to be measured, obtaining a first phase difference signal according to the reference clock signal and the clock signal to be measured, and outputting the first phase difference signal to the phase comparison assembly; obtaining, by the phase comparison assembly, a phase adjustment signal according to the first phase difference signal, and outputting the phase adjustment signal to the signal processing assembly; and performing, by the signal processing assembly, phase adjustment on the reference clock signal according to the phase adjustment signal so as to reduce the first phase difference signal, adding up the adjusted phase values so as to obtain a cumulative phase value, and obtaining, according to the cumulative phase value and the initial phase, a phase of the clock signal to be measured.

An embodiment in accordance with yet another aspect of the present disclosure provides a device including the phase detection apparatus as described in the above embodiment.

Additional features and advantages of the present disclosure will be set forth in the subsequent description, and in part will become apparent from the description, or may be learned by practice of the present disclosure. The purposes and other advantages of the present disclosure can be realized and obtained by structures specified in the description, the claims and the accompanying drawings.

## BRIEF DESCRIPTION OF DRAWINGS

The accompanying drawings are used to provide an understanding of the technical schemes of the present disclosure and constitute a part of the description. The accompanying drawings are used to explain the technical schemes of the present disclosure together with the embodiments of the present disclosure, and do not constitute a restriction on the technical schemes of the present disclosure.

Fig. 1 is a schematic diagram of a phase detection apparatus provided by an embodiment of the present disclosure;
Fig. 2 is a schematic diagram of a phase detection apparatus provided by another embodiment of the present disclosure;
Fig. 3 is a schematic diagram of a phase detection apparatus provided by another embodiment of the present disclosure;
Fig. 4 is a schematic diagram of a phase detection apparatus provided by another embodiment of the present disclosure;
Fig. 5 is a schematic diagram of a phase detection apparatus provided by another embodiment of the present disclosure;
Fig. 6 is a flowchart of a phase detection method provided by an embodiment of the present disclosure;
Fig. 7 is a flowchart of a phase detection method provided by another embodiment of the present disclosure;
Fig. 8 is a flowchart of a phase detection method provided by another embodiment of the present disclosure;
Fig. 9 is a flowchart of a phase detection method provided by another embodiment of the present disclosure;
Fig. 10 is a flowchart of a phase detection method provided by another embodiment of the present disclosure; and
Fig. 11 is a schematic diagram of a device provided by an embodiment of the present disclosure.

## DETAILED DESCRIPTION

In order to make the objectives, technical schemes and advantages of the present disclosure more apparent, the present disclosure is described in detail in conjunction with the accompanying drawings and embodiments. It should be understood that the embodiments described here are only intended to explain the present disclosure and are not intended to limit the present disclosure.

It should be noted that although a functional module division is shown in the schematic diagrams of the device and a logical order is shown in the flowcharts, the steps shown or described may be performed, in some cases, in a different module division from that of the device or in a different order from that in the flowcharts. The terms "first", "second", etc. in the description, the claims and the above-mentioned drawings are intended to distinguish between similar objects and are not necessarily to describe a specific order or sequence.

Embodiments of the present disclosure provide a phase detection method and apparatus, and a device, where the phase detection apparatus includes a signal processing assembly, a phase discrimination component and a phase comparison assembly which are sequentially in a head-totail manner. The phase comparison assembly obtains a phase adjustment signal according to a first phase difference signal output by the phase discrimination component, where the first phase difference signal is obtained by the phase discrimination component according to a reference clock signal and a clock signal to be measured. The signal processing assembly performs phase adjustment on the reference clock signal according to the phase adjustment signal so as to reduce the first phase difference signal. In other words, phase adjustment is performed on the reference clock signal to gradually reduce the first phase difference signal output by the phase discrimination component according to the reference clock signal and the clock signal to be measured, so that the phase of the reference clock signal can approach a phase of the clock signal to be measured, thereby gradually improving accuracy of the first phase difference signal output by the phase discrimination component, and improving phase detection accuracy of the clock signal. In addition, because the phase adjustment is performed on the reference clock signal within a numerical range of the first phase difference signal for the purpose of reducing the first phase difference signal, phase detection of the clock signal can be realized by only a limited number of times of processing within the numerical range of the first phase difference signal. Such manner has a higher phase detection speed compared with a manner of obtaining phase information over one clock period in some cases. Therefore, accuracy and speed of phase detection on the clock signal can be improved.

The embodiments of the present disclosure will be explained below with reference to the accompanying drawings.

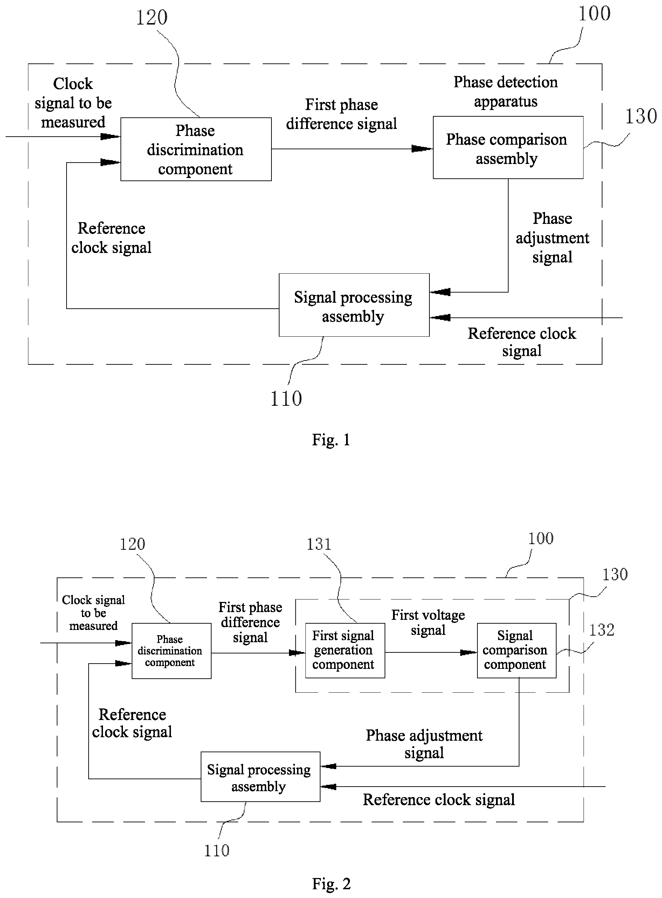

As shown in Fig. 1, a schematic diagram of a phase detection apparatus provided by an embodiment of the present disclosure is depicted. As illustrated in Fig. 1, the phase detection apparatus 100 includes a signal processing assembly 110, a phase discrimination component 120, and a phase comparison assembly 130 serially connected in a loop. The signal processing assembly 110 is configured to acquire a reference clock signal and an initial phase of the reference clock signal and output the reference clock signal; the phase discrimination component 120 is configured to acquire a clock signal to be measured and obtain and output a first phase difference signal according to the reference clock signal and the clock signal to be measured; and the phase comparison assembly 130 is configured to obtain and output a phase adjustment signal according to the first phase difference signal. In addition, the signal processing assembly 110 is further configured to perform phase adjustment on the reference clock signal according to the phase adjustment signal so as to reduce the first phase difference signal; add up the adjusted phase values so as to obtain a cumulative phase value; and obtain, according to the cumulative phase value and the initial phase, a phase of the clock signal to be measured. Therefore, the signal processing assembly 110, the phase discrimination component 120, and the phase comparison assembly 130 can collaborate with each other to realize phase detection of the clock signal.

In an embodiment, the clock signal to be measured is a clock signal requiring phase detection, and the reference clock signal is a known clock signal which is used to detect the phase of the clock signal to be measured. When the signal processing assembly 110 obtains the reference clock signal for the first time, the signal processing assembly 110 can obtain the initial phase of the reference clock signal, which is a prerequisite to obtaining the phase of the clock signal to be measured in a subsequent operation.

In an embodiment, the first phase difference signal is a signal obtained by the phase discrimination component 120 according to the reference clock signal and the clock signal to be measured. Due to limitation of a manufacturing process or calculation precision of the phase discrimination component 120, the first phase difference signal output by the phase discrimination component 120 is not accurate. In view of this, the signal processing assembly 110 and the phase comparison assembly 130 are provided, such that the signal processing assembly 110, the phase discrimination component 120, and the phase comparison assembly 130 are serially connected in a loop. The phase comparison section 130 can obtain a phase adjustment signal according to the first phase difference signal output by the phase discrimination component 120, and the signal processing assembly 110 can perform phase adjustment on the reference clock signal according to the phase adjustment signal so as to reduce the value of the first phase difference signal. In other words, through mutual collaboration among the phase discrimination component 120, the phase comparison assembly 130, and the signal processing assembly 110, phase adjustment is performed on the reference clock signal to gradually reduce the first phase difference signal output by the phase discrimination component 120, so that the phase of the reference clock signal can gradually approach the phase of the clock signal to be measured, thereby improving accuracy of the first phase difference signal obtained by the phase discrimination component 120 according to the reference clock signal and the clock signal to be measured. In addition, because the phase adjustment is performed on the reference clock signal within a numerical range of the first phase difference signal for the purpose of reducing the first phase difference signal, phase detection of the clock signal to be measured can be realized by only a limited number of times of processing within the numerical range of the first phase difference signal. This embodiment has a higher phase detection speed compared with a manner of obtaining phase information by traversing over one clock period in some cases. Therefore, this embodiment can improve accuracy and speed of phase detection on the clock signal.

In an embodiment, the signal processing assembly 110 includes a field programmable gate array (FPGA) chip configured with a function of a phase shifter, or includes a combination of a digital signal processor (DSP) chip and a digital phase shifter, which is not specifically limited in this embodiment. In a case that the signal processing assembly 110 includes a combination of a DSP chip and a digital phase shifter, the digital phase shifter may acquire a reference clock signal, and the DSP chip may obtain a reference clock signal and an initial phase of the reference clock signal and output a configuration signal to the digital phase shifter according to the phase adjustment signal output by the phase comparison assembly 130, so that the digital phase shifter performs phase adjustment on the reference clock signal according to the configuration signal so as to reduce the first phase difference signal obtained by the phase discrimination component 120 according to the reference clock signal and the clock signal to be measured. In addition, the DSP chip may add up the phase values of phase adjustment on the reference clock signal, and obtain a phase of the clock signal to be measured according to a cumulative phase value and the initial phase of the reference clock signal.

In an embodiment, the phase discrimination component 120 may use a digital phase discriminator or an analog phase discriminator. In a case that the phase discrimination component 120 uses a digital phase discriminator, the phase discrimination component 120 may be an independent digital phase discriminator or a digital phase discriminator integrated in the signal processing assembly 110, for example, the phase discrimination component 120 may be a functional component in the FPGA chip. An implementation of the phase discrimination component 120 is not specifically limited in this embodiment.

In an embodiment, the phase comparison assembly 130 may include a signal processing chip such as an FPGA chip or may include a logic processing chip such as a comparator, which is not specifically limited in this embodiment.

In a case that the phase comparison assembly 130 includes a signal processing chip such as the FPGA chip, when the phase comparison assembly 130 receives the first phase difference signal output by the phase discrimination component 120, the phase comparison assembly 130 may first determine whether the first phase difference signal meets a preset condition. In response to the preset condition being met, the phase comparison assembly 130 outputs a corresponding phase adjustment signal. For example, when the phase comparison assembly 130 determines that the first phase difference signal is within a first preset range, the phase comparison assembly 130 may output a phase adjustment signal of a positive phase shift on the reference clock signal; or when the phase comparison assembly 130 determines that the first phase difference signal is within a second preset range, the phase comparison assembly 130 may output a phase adjustment signal of a negative phase shift on the reference clock signal. It is worth noting that the preset condition may be appropriately set according to an actual application requirement, which is not specifically limited in this embodiment. In addition, the first preset range and the second preset range may be appropriately set according to an actual application requirement, which is not specifically limited in this embodiment.

In a case that the phase comparison assembly 130 includes a logic processing chip such as the comparator, when the phase comparison assembly 130 receives the first phase difference signal output by the phase discrimination component 120, the phase comparison assembly 130 may logically compare the first phase difference signal with a reference signal and output a corresponding phase adjustment signal according to the comparison of the first phase difference signal and the reference signal. For example, in response to the first phase difference signal being larger than the reference signal, the phase comparison assembly 130 may output a phase adjustment signal of a negative phase shift on the reference clock signal; or in response to the first phase difference signal being less than the reference signal, the phase comparison assembly 130 may output a phase adjustment signal of a positive phase shift on the reference clock signal. It is worth noting that the reference signal may be a signal set according to experience or a signal related to the reference clock signal, and may be appropriately set according to an actual application requirement, which is not specifically limited in this embodiment.

In an embodiment, as referring to Fig. 2, the phase comparison assembly 130 includes, but is not limited to, a first signal generation component 131 and a signal comparison component 132, where the first signal generation component 131 is connected to the phase discrimination component 120, and the signal comparison component 132 is connected to each of the first signal generation component 131 and the signal processing assembly 110. The first signal generation component 131 may be configured to obtain a first voltage signal according to the first phase difference signal. The signal comparison component 132 may be configured to acquire a reference voltage signal and the first voltage signal, and obtain, according to the reference voltage signal and the first voltage signal, the phase adjustment signal used for phase adjustment on the reference clock signal.

In an embodiment, the first signal generation component 131 is a charge pump which is also referred to as a switched capacitor voltage converter, capable of outputting a voltage value through charge storage. After receiving the first phase difference signal output by the phase discrimination component 120, the first signal generation component 131 may charge for a duration indicated by the first phase difference signal and obtain the first voltage signal, which is a prerequisite to obtaining the phase adjustment signal in a subsequent process.

In an embodiment, the signal comparison component 132 is a voltage comparator. The reference voltage signal may be a voltage signal set according to experience or a voltage signal related to the reference clock signal, and may be appropriately set according to an actual application requirement, which is not specifically limited in this embodiment. After acquiring the reference voltage signal and the first voltage signal, the signal comparison component 132 may obtain, according to the reference voltage signal and the first voltage signal, the phase adjustment signal used for phase adjustment on the reference clock signal. For example, in response to a voltage value of the first voltage signal being larger than a voltage value of the reference voltage signal, the signal comparison component 132 may output a phase adjustment signal with a level value of a high level, where the phase adjustment signal with a level value of a high level may be set as an indication for the signal processing assembly 110 to perform a negative phase shift on the reference clock signal; in response to the voltage value of the first voltage signal being less than the voltage value of the reference voltage signal, the signal comparison component 132 may output a phase adjustment signal with a level value of a low level, where the phase adjustment signal with a level value of a low level may be set as an indication for the signal processing assembly 110 to perform a positive phase shift on the reference clock signal; and in response to the voltage value of the first voltage signal being equal to the voltage value of the reference voltage signal, the signal comparison component 132 may output a phase adjustment signal with a level value of a medium level, where the phase adjustment signal with a level value of a medium level may be set as an indication for the signal processing assembly 110 to stop performing phase adjustment on the reference clock signal. It is worth noting that, the medium level is a level between the high level and the low level. Therefore, the first signal generation component 131 and the signal comparison component 132 collaborate with each other, providing an accurate adjustment direction for the signal processing assembly 110 to perform phase adjustment on the reference clock signal, so that the phase of the reference clock signal can approach the phase of the clock signal to be measured, thereby gradually improving accuracy of the first phase difference signal output by the phase discrimination component 120, and improving phase detection accuracy of the clock signal.

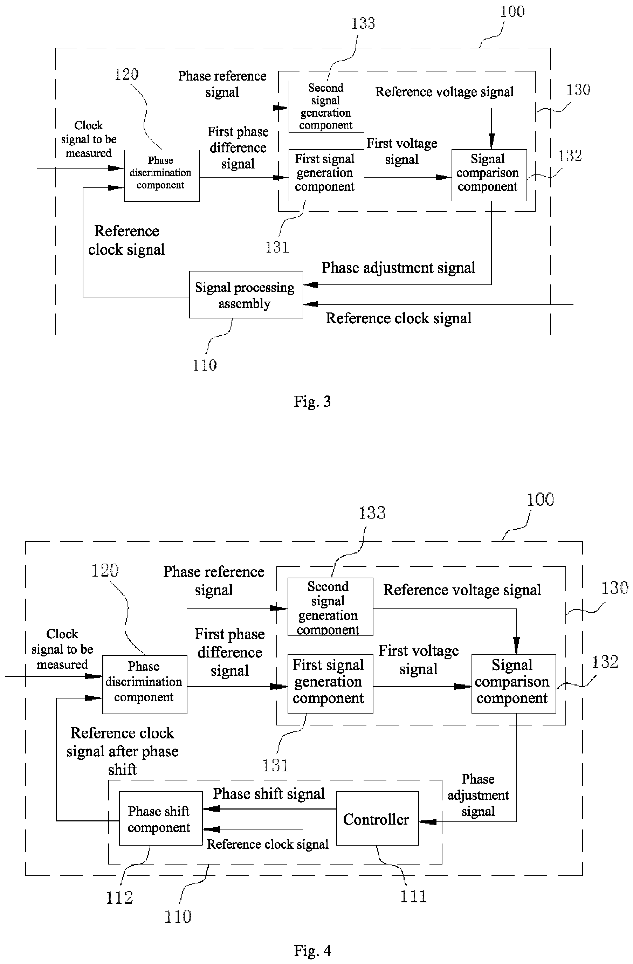

In an embodiment, as referring to Fig. 3, the phase comparison assembly 130 includes a second signal generation component 133, where the second signal generation component 133 is connected to the signal comparison component 132. The second signal generation component 133 may be configured to acquire a phase reference signal, and obtain the reference voltage signal according to the phase reference signal, where the phase reference signal is obtained according to the reference clock signal.

In an embodiment, the second signal generation component 133 is a charge pump which is also referred to as a switched capacitor voltage converter, capable of outputting a voltage value through charge storage. After receiving a phase reference signal, the second signal generation component 133 may charge for a duration indicated by the phase reference signal and obtain the reference voltage signal, which is a prerequisite to obtaining the phase adjustment signal in a subsequent process.

In an embodiment, the phase reference signal is obtained according to a period of the reference clock signal. For example, the phase reference signal may be a half of the period of the reference clock signal or a quarter of the period of the reference clock signal, which may be appropriately selected according to an actual use requirement and is not specifically limited in this embodiment.

In an embodiment, as the phase reference signal is a fixed value preset, the reference voltage signal obtained by the second signal generation component 133 by charging for the duration indicated by the phase reference signal is also a fixed value, which facilitates comparison between the reference voltage signal and the first voltage signal to obtain a phase adjustment signal.

In an embodiment, as referring to Fig. 4, the signal processing assembly 110 includes, but is not limited to, a controller 111 and a phase shift component 112, where the phase comparison assembly 130, the controller 111, the phase shift component 112, and the phase discrimination component 120 are connected in sequence. The controller 111 may be configured to acquire the initial phase of the reference clock signal, obtain a phase shift signal according to the phase adjustment signal output by the phase comparison assembly 130, and send the phase shift signal to the phase shift component 112. The phase shift component 112 may be configured to acquire the reference clock signal and perform phase adjustment on the reference clock signal according to the phase shift signal so as to reduce the first phase difference signal output by the phase discrimination component 120 according to the reference clock signal and the clock signal to be measured. Additionally, the controller 111 may be configured to add up the phase shift signals to obtain a cumulative phase value, and obtain, according to the cumulative phase value and the initial phase of the reference clock signal, the phase of the clock signal to be measured.

In an embodiment, the controller 111 has various possible implementations. For example, the controller 111 may be an FPGA chip, a DSP chip, or a combination of a control chip and a binary frequency divider, which is not specifically limited in this embodiment. In a case that the controller 111 is a combination of a control chip and a binary frequency divider, the binary frequency divider may be responsible for generating binary information (for example, the phase shift signal in this embodiment), and the control chip may be responsible for configuring the binary information to the phase shift component 112 so that the phase shift component 112 can adjust a shifting degree of the phase of the reference clock signal according to the binary information. In addition, the phase shift component 112 may also have various implementations, for example, the phase shift component 112 may be a digital phase shifter or an analog phase shifter having a configuration function, which is not specifically limited in this embodiment.

In an embodiment, during collaboration with the phase shift component 112 for performing phase adjustment on the reference clock signal, the controller 111 adds up the phase shift signals to obtain a cumulative phase value, so that when the detection is completed, the phase of the clock signal to be measured can be obtained according to the cumulative phase value and the initial phase of the reference clock signal, thereby realizing detection processing of the phase of the clock signal to be measured. An example is provided herein for description. After the controller receives the phase adjustment signal, the controller may obtain a phase shift

signal $\dfrac{1}{2^{k+1}}T$ according to the phase adjustment signal, where k is the number of times of phase adjustment performed on the reference clock signal, and T is the period of the reference clock signal. Therefore, when the controller adds up the phase shift signals, the cumulative phase value can be obtained as $\displaystyle\sum_{k=1}^{n}\left(\pm\dfrac{1}{2^{k+1}}T\right)$.

In an embodiment, in a case that the phase comparison assembly 130 includes the signal comparison component 132 which outputs, to the controller 111, the phase adjustment signal used for phase adjustment on the reference clock signal, the controller 111 sends different types of configuration information to the phase shift component 112 according to different types of phase adjustment signals, so that the phase shift component 112 can perform different phase adjustment processing on the reference clock signal according to the different types of configuration information. For example, in response to a level value of the phase adjustment signal being a high level, the controller 111 may send, to the phase shift component 112, one piece of configuration information indicating a negative phase shift, so that the phase shift component 112 performs a negative phase shift on the reference clock signal according to the configuration information indicating a negative phase shift; in response to a level value of the phase adjustment signal being a low level, the controller 111 may send, to the phase shift component 112, one piece of configuration information indicating a positive phase shift, so that the phase shift component 112 performs a positive phase shift on the reference clock signal according to the configuration information indicating a positive phase shift; or in response to a level value of the phase adjustment signal being a medium level, the controller 111 does not send any configuration information to the phase shift component 112, so that the phase shift component 112 does not perform phase adjustment on the reference clock signal. It is worth noting that, the medium level is a level between the high level and the low level. Therefore, mutual collaboration between the controller 111 and the phase shift component 112 enables phase adjustment performed on the reference clock signal in an accurate adjustment direction, so that the phase of the reference clock signal can approach the phase of the clock signal to be measured, thereby gradually improving accuracy of the first phase difference signal output by the phase discrimination component 120, and improving phase detection accuracy of the clock signal.

In an embodiment, the signal processing assembly 110 further includes a counter, where the counter may be built in the controller 111 or disposed outside the controller 111 and connected to the controller 111.

In an embodiment, a count value of the counter is set not only to the number of times of phase adjustment performed by the signal processing assembly 110 on the reference clock signal, but also to an obtained phase shift signal used to adjust the phase of the reference clock signal.

In an embodiment, a maximum count value is set for the counter. When a current count value of the counter reaches the maximum count value, that is, the number of times of phase adjustment performed by the signal processing assembly 110 on the reference clock signal reaches a preset maximum number of times, or when the controller 111 receives a phase adjustment signal with a level value of a medium level, the controller 111 will reset the counter to 0. The controller 111 resetting the counter indicates that the phase measurement is completed, and a next phase detection will be performed. It is worth noting that, the medium level is a level between the high level and the low level.

In an embodiment, the controller 111 is configured to obtain, using the following formula and according to the cumulative phase value and the initial phase, a phase of the clock signal to be measured:

$$T1 = \left( T2 + \frac{1}{2}T \right) + \sum_{k=1}^{n}\left( \pm\frac{1}{2^{k+1}}T \right)$$

where T1 is the phase of the clock signal to be measured; T2 is the initial phase of the reference clock signal;

$$\sum_{k=1}^{n}\left( \pm\frac{1}{2^{k+1}}T \right)$$

is the cumulative phase value; T is the period of the reference clock signal; and n is the number of times of phase adjustment performed on the reference clock signal, and n ≥ 1.

In an embodiment, $\frac{1}{2^{k+1}}T$ determines accuracy of phase detection. An example is provided for description below.

For example, phase detection needs to be performed on a timestamp clock signal with a frequency of 125 MHz and a period of 8 ns. In this case, the phase detection apparatus 100 of this embodiment performs, by using a reference clock signal with the same frequency as the clock signal given a timestamp, phase detection on the clock signal given a timestamp. When the maximum count value of the counter is set to 10, that is, the number of times of phase adjustment performed by the signal processing assembly 110 on the reference clock signal is set to 9 (the phase of the reference clock signal is not adjusted at the first time), then, in this case, final measurement accuracy obtained according to the above formula is about 8 ps. However, if the measurement is performed in a manner of obtaining phase information over one clock period in some cases, to achieve the same measurement accuracy, phase information is obtained by operations over one clock period with a step size of 8 ps, phase shifting needs to be performed 1000 times. Therefore, compared with such cases, this embodiment has a higher phase detection speed. In addition, it can be learned from the example that in a case of performing the same number of phase shifts, this embodiment has better phase detection accuracy compared with the above-described cases.

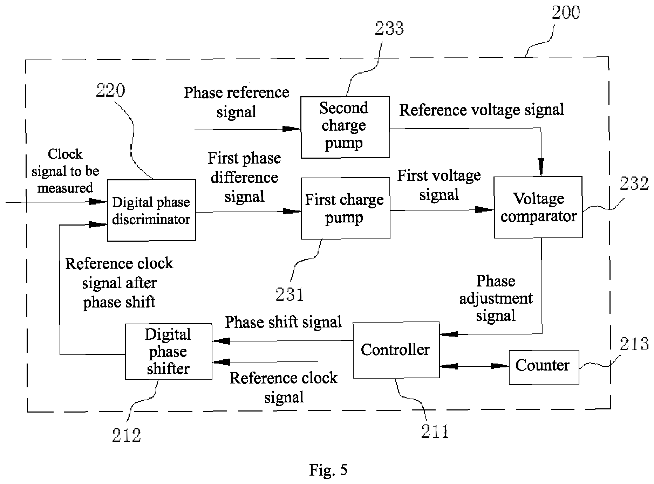

Another embodiment of the present disclosure, as referring to Fig. 5, also provides a phase detection apparatus 200. The phase detection apparatus 200 includes a controller 211, a digital phase shifter 212, a digital phase discriminator 220, a first charge pump 231, a voltage comparator 232, a second charge pump 233, and a counter 213. The controller 211, the digital phase shifter 212, the digital phase discriminator 220, the first charge pump 231, and the voltage comparator 232 are serially connected in a loop. The controller 211 is also connected to the counter 213, and the voltage comparator 232 is also connected to the second charge pump 233.

Referring to Fig. 5, when the phase detection apparatus 200 performs phase detection on a clock signal to be measured, the components in the phase detection apparatus 200 perform operations in collaboration according to the following detection principles.

Before phase detection is performed, the second charge pump 233 charges for a duration of $\dfrac{T}{2}$ to obtain a reference voltage signal having a voltage value of Vref, where T is a period of a reference clock signal. The second charge pump 233 sends the reference voltage signal to the voltage comparator 232.

The controller 211 sets a maximum count value n of the counter 213 and causes the counter 213 to count from 0.

Before the phase detection is performed, because a current count value of the counter 213 is 0, phase adjustment is not performed on the reference clock signal. In this case, the digital phase shifter 212 outputs an initial reference clock signal to the digital phase discriminator 220, and the digital phase discriminator 220 obtains and outputs a first phase difference signal to the first charge pump 231 according to the initial reference clock signal and the clock signal to be measured. Then, the first charge pump 231 charges for a duration indicated by the first phase difference signal, and outputs a first voltage signal to the voltage comparator 232, and the voltage comparator 232 obtains and outputs a phase adjustment signal to the controller 211 according to the first voltage signal and the reference voltage signal.

When the controller 211 receives the phase adjustment signal, the controller 211 starts to perform phase detection on the clock signal to be measured. At this time, the count value of the counter 213 is increased by 1. In response to a level value of the phase adjustment signal being a high level, the controller 211 collaborates with the digital phase shifter 212 to perform a negative phase shift on the reference clock signal by a displacement of $\dfrac{T}{4}$, so that a phase of the reference clock signal can approach a phase of the clock signal to be measured. In response to a level value of the phase adjustment signal being a low level, the controller 211 collaborates with the digital phase shifter 212 to perform a positive phase shift on the reference clock signal by a displacement of $\dfrac{T}{4}$, so that a phase of the reference clock signal can approach the phase of the clock signal to be measured.

When the controller 211 and the digital phase shifter 212 collaborate to adjust the phase of the reference clock signal, the phase-adjusted reference clock signal is input to the digital phase discriminator 220. In this case, the digital phase discriminator 220 obtains and outputs a new first phase difference signal according to the phase-adjusted reference clock signal and the clock signal to be measured, and the first charge pump 231

and the voltage comparator 232 collaborate with each other to output a new phase adjustment signal to the controller 211 according to the new first phase difference signal. Cyclic detection operations are performed until the count value of the counter 213 reaches the preset maximum count value, thereby completing the phase detection of the clock signal to be measured. At this time, a result can be obtained as follows:

$$T1 = \left(T2 + \frac{1}{2}T\right) + \sum_{k=1}^{n}\left(\pm\frac{1}{2^{k+1}}T\right)$$

where T1 is the phase of the clock signal to be measured; T2 is the initial phase of the reference clock signal; $\displaystyle\sum_{k=1}^{n}\left(\pm\frac{1}{2^{k+1}}T\right)$ is the cumulative phase value; T is the period of the reference clock signal; and n is the number of times of phase adjustment performed on the reference clock signal, and $n \geq 1$.

It should be noted that the level value of the phase adjustment signal being a medium level (that is, a level between a high level and a low level) indicates that a difference of a half period exists between the phase of the reference clock signal and the phase of the clock signal to be measured. In this case, phase adjustment is no longer performed on the reference clock signal, and the phase detection operation is completed. In this case, the phase of the clock signal to be measured may also be obtained according to the above formula, which will not be described in details herein.

The apparatus embodiments described above are only for illustration. The units described as separate components may or may not be physically separated, that is, they may be located at one place or distributed to multiple network units. Some or all of the modules can be selected according to actual needs to achieve the purpose of this embodiment.

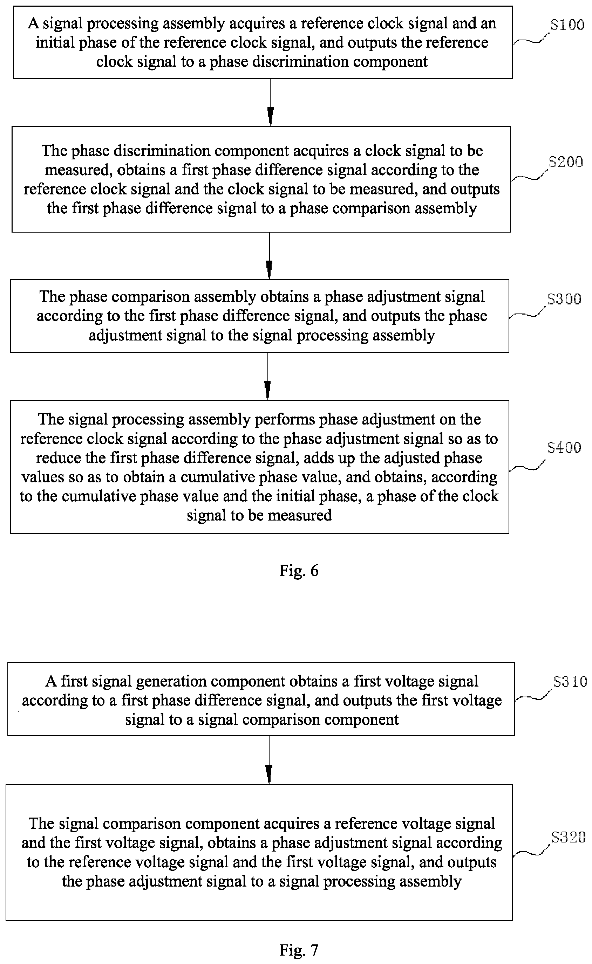

In an embodiment, as referring to Fig. 6, an embodiment of the present disclosure also provides a phase detection method, which can be applied to a phase detection apparatus in the apparatus embodiment described above. The phase detection method includes but is not limited to the following steps.

At S100, a signal processing assembly acquires a reference clock signal and an initial phase of the reference clock signal, and outputs the reference clock signal to a phase discrimination component.

At S200, the phase discrimination component acquires a clock signal to be measured, obtains a first phase difference signal according to the reference clock signal and the clock signal to be measured, and outputs the first phase difference signal to a phase comparison assembly.

At S300, the phase comparison assembly obtains a phase adjustment signal according to the first phase difference signal, and outputs the phase adjustment signal to the signal processing assembly.

At S400, the signal processing assembly performs phase adjustment on the reference clock signal according to the phase adjustment signal so as to reduce the first phase difference signal, adds up the adjusted phase values so as to obtain a cumulative phase value, and obtains, according to the cumulative phase value and the initial phase, a phase of the clock signal to be measured.

In an embodiment, the clock signal to be measured is a clock signal requiring phase detection, and the reference clock signal is a known clock signal which is used to detect the phase of the clock signal to be measured. When the signal processing assembly obtains the reference clock signal for the first time, the signal processing assembly can obtain the initial phase of the reference clock signal, which is a prerequisite to obtaining the phase of the clock signal to be measured in a subsequent operation.

In an embodiment, the first phase difference signal is a signal obtained by the phase discrimination component according to the reference clock signal and the clock signal to be measured. Due to limitation of a manufacturing process or calculation precision of the phase discrimination component, the first phase difference signal output by the phase discrimination component is not accurate. In view of this, the first phase difference signal output by the phase discrimination component is sent to the phase comparison assembly, and the phase comparison assembly can obtain a phase adjustment signal according to the first phase difference signal and send the phase adjustment signal to the signal processing assembly. Then, the signal processing assembly can perform phase adjustment on the reference clock signal according to the phase adjustment signal so as to reduce the value of the first phase difference signal. In other words, through mutual collaboration among the phase discrimination component, the phase comparison assembly, and the signal processing assembly, phase adjustment is performed on the reference clock signal to gradually reduce the first phase difference signal output by the phase discrimination component, so that the phase of the reference clock signal can gradually approach the phase of the clock signal to be measured, thereby improving accuracy of the first phase difference signal obtained by the phase discrimination component according to the reference clock signal and the clock signal to be measured. In addition, because the phase adjustment is performed on the reference clock signal within a numerical range of the first phase difference signal for the purpose of reducing the first phase difference signal, phase detection of the clock signal to be measured can be realized by only a limited number of times of processing within the numerical range of the first phase difference signal. This embodiment has a higher phase detection speed compared with a manner of obtaining phase information by traversing over one clock period in some cases. Therefore, this embodiment can improve accuracy and speed of phase detection on the clock signal.

It is worth noting that since the phase detection method of this embodiment can be applied to the phase detection apparatus in the apparatus embodiment described above. Therefore, for detailed implementations of the signal processing assembly, the phase discrimination component and the phase comparison assembly in this embodiment, reference may be made to the related descriptions in the apparatus embodiment described above, and details will not be repeated herein.

In an embodiment, the phase comparison assembly includes a first signal generation component and a signal comparison component, and the signal processing assembly, the phase discrimination component, the first signal generation component and the signal comparison component are serially connected in a loop. Then, referring to Fig. 7, step S300 includes, but is not limited to, the following sub-steps.

At S310, the first signal generation component obtains a first voltage signal according to the first phase difference signal, and outputs the first voltage signal to the signal comparison component.

At S320, the signal comparison component acquires a reference voltage signal and the first voltage signal, obtains the phase adjustment signal according to the reference voltage signal and the first voltage signal, and outputs the phase adjustment signal to the signal processing assembly.

In an embodiment, the first signal generation component is a charge pump which is also referred to as a switched capacitor voltage converter, capable of outputting a voltage value through charge storage. After receiving the first phase difference signal output by the phase discrimination component, the first signal generation component may charge for a duration indicated by the first phase difference signal and obtain the first voltage signal, which is a prerequisite to obtaining the phase adjustment signal in a subsequent step.

In an embodiment, the reference voltage signal is a voltage signal set according to experience or a voltage signal related to the reference clock signal, and may be appropriately set according to an actual application requirement, which is not specifically limited in this embodiment.

In an embodiment, after the signal comparison component acquires the reference voltage signal and the first voltage signal, the signal comparison component obtains, according to the reference voltage signal and the first voltage signal, the phase adjustment signal used for phase adjustment on the reference clock signal. For example, in response to a voltage value of the first voltage signal being larger than a voltage value of the reference voltage signal, the signal comparison component may output a phase adjustment signal with a level value of a high level, where the phase adjustment signal with a level value of a high level may be set as an indication for the signal processing assembly to perform a negative phase shift on the reference clock signal. For another example, in response to the voltage value of the first voltage signal being less than the voltage value of the reference voltage signal, the signal comparison component may output a phase adjustment signal with a level value of a low level, where the phase adjustment signal with a level value of a low level may be set as an indication for the signal processing assembly to perform a positive phase shift on the reference clock signal. For another example, in response to the voltage value of the first voltage signal being equal to the voltage value of the reference voltage signal, the signal comparison component may output a phase adjustment signal with a level value of a medium level (that is, a level between the high level and the low level), where the phase adjustment signal with a level value of a medium level may be set as an indication for the signal processing assembly to stop performing phase adjustment on the reference clock signal. It is worth noting that the examples in which the signal comparison component obtains the phase adjustment signal according to the reference voltage signal and the first voltage signal may be combined for use according to an actual situation, which will not be described in details herein to avoid repetition.

In an embodiment, the first signal generation component and the signal comparison component collaborate with each other, providing an accurate adjustment direction for the signal processing assembly to perform phase adjustment on the reference clock signal, so that the phase of the reference clock signal can approach the phase of the clock signal to be measured, thereby gradually improving accuracy of the first phase difference signal output by the phase discrimination component, and improving phase detection accuracy of the clock signal.

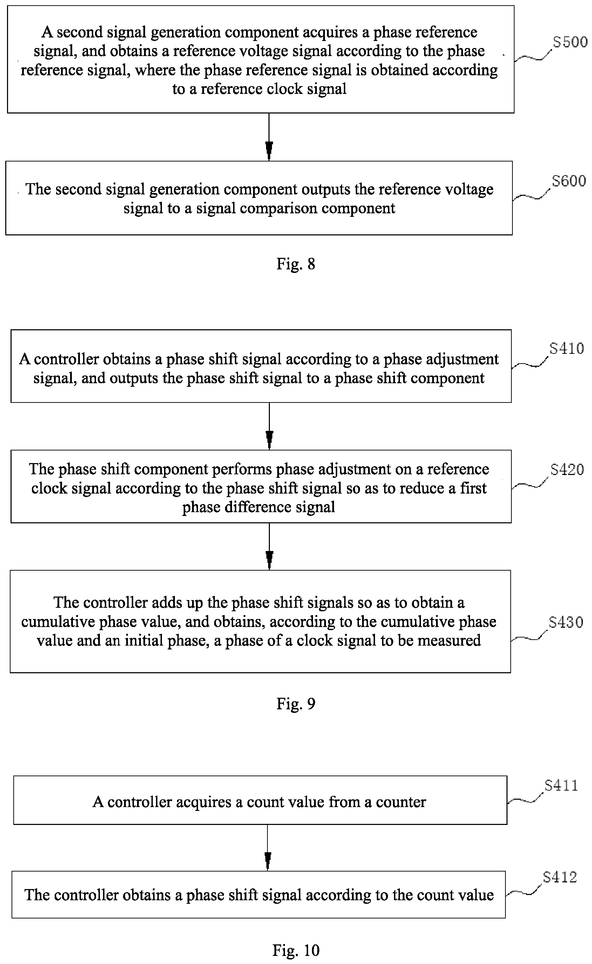

In an embodiment, the phase comparison assembly further includes a second signal generation component, the second signal generation component being connected to the signal comparison component. Then, referring to Fig. 8, the phase detection method further includes the following steps.

At S500, the second signal generation component acquires a phase reference signal, and obtains the reference voltage signal according to the phase reference signal, where the phase reference signal is obtained according to the reference clock signal.

At S600, the second signal generation component outputs the reference voltage signal to the signal comparison component.

In an embodiment, the second signal generation component is a charge pump which is also referred to as a switched capacitor voltage converter, capable of outputting a voltage value through charge storage. After receiving a phase reference signal, the second signal generation component may charge for a duration indicated by the phase reference signal and obtain the reference voltage signal, which is a prerequisite to obtaining the phase adjustment signal in a subsequent step.

In an embodiment, the phase reference signal is obtained according to a period of the reference clock signal. For example, the phase reference signal may be a half of the period of the reference clock signal or a quarter of the period of the reference clock signal, which may be appropriately selected according to an actual use requirement and is not specifically limited in this embodiment.

In an embodiment, the operation of performing phase adjustment on the reference clock signal by the signal processing assembly according to the phase adjustment signal in S400 includes different sub-steps in different embodiments.

At S401, in response to a level value of the phase adjustment signal being a high level, the signal processing assembly performs a negative phase shift on the reference clock signal.

At S402, in response to a level value of the phase adjustment signal being a low level, the signal processing assembly performs a positive phase shift on the reference clock signal.

At S403, in response to a level value of the phase adjustment signal being a medium level, the signal processing assembly skips phase adjustment on the reference clock signal, where the medium level is a level between the high level and the low level.

It is worth noting that steps S401, S402 and S403 may be independent steps or may be combined form different technical schemes, which may be appropriately selected according to an actual situation, and is not specifically limited in this embodiment.

In an embodiment, according to different level values of the phase adjustment signal, the signal processing assembly can perform phase adjustment on the reference clock signal in different directions, so that the phase of the reference clock signal can approach the phase of the clock signal to be measured, thereby gradually improving accuracy of the first phase difference signal output by the phase discrimination component, and improving phase detection accuracy of the clock signal.

In an embodiment, the signal processing assembly includes a controller and a phase shift component, and the phase comparison assembly, the controller, the phase shift component and the phase discrimination component are serially connected in a loop. Then, referring to Fig. 9, step S400 includes, but is not limited to, the following sub-steps.

At S410, the controller obtains a phase shift signal according to the phase adjustment signal, and outputs the phase shift signal to the phase shift component.

At S420, the phase shift component performs phase adjustment on the reference clock signal according to the phase shift signal so as to reduce the first phase difference signal.

At S430, the controller adds up the phase shift signals so as to obtain a cumulative phase value, and obtains, according to the cumulative phase value and the initial phase, the phase of the clock signal to be measured.

In an embodiment, during collaboration with the phase shift component for performing phase adjustment on the reference clock signal, the controller adds up the phase shift signals to obtain a cumulative phase value, so that when the detection is completed, the phase of the clock signal to be measured can be obtained according to the cumulative phase value and the initial phase of the reference clock signal, thereby realizing detection processing of the phase of the clock signal to be measured. An example is provided herein for description. After the controller receives the phase adjustment signal, the controller may obtain a phase shift signal $\frac{1}{2^{k+1}}T$ according to the phase adjustment signal, where k is the number of times of phase adjustment performed on the reference clock signal, and T is the period of the reference clock signal. Therefore, when the controller adds up the phase shift signals, the cumulative phase value can be obtained as $\sum_{k=1}^{n}\left(\pm\frac{1}{2^{k+1}}T\right)$.

In an embodiment, after receiving the phase adjustment signal, the controller sends different types of configuration information to the phase shift component according to different types of phase adjustment signals, so that the phase shift component can perform different phase adjustment processing on the reference clock signal according to the different types of configuration information. For example, in response to a level value of the phase adjustment signal being a high level, the controller may send, to the phase shift component, one piece of configuration information indicating a negative phase shift, so that the phase shift component performs a negative phase shift on the reference clock signal according to the configuration information indicating a negative phase shift; in response to a level value of the phase adjustment signal being a low level, the controller may send, to the phase shift component, one piece of configuration information indicating a positive phase shift, so that the phase shift component performs a positive phase shift on the reference clock signal according to the configuration information indicating a positive phase shift; or in response to a level value of the phase adjustment signal being a medium level, the controller does not send any configuration information to the phase shift component, so that the phase shift component does not perform phase adjustment on the reference clock signal. It is worth noting that, the medium level is a level between the high level and the low level. Therefore, mutual collaboration between the controller and the phase shift component enables phase adjustment performed on the reference clock signal in an accurate adjustment direction, so that the phase of the reference clock signal can approach the phase of the clock signal to be measured, thereby gradually improving accuracy of the first phase difference signal output by the phase discrimination component, and improving phase detection accuracy of the clock signal.

In an embodiment, the signal processing assembly further includes a counter built in the controller or disposed outside the controller and connected to the controller. Then, referring to Fig. 10, the operation of obtaining a phase shift signal by the controller according to the phase adjustment signal in S410 includes the following sub-steps.

At S411, the controller acquires a count value from the counter.

At S412, the controller obtains the phase shift signal according to the count value.

In an embodiment, a count value of the counter is set not only to the number of times of phase adjustment performed by the signal processing assembly on the reference clock signal, but also to an obtained phase shift signal used to adjust the phase of the reference clock signal. Therefore, acquisition of the count value of the counter facilitates obtaining the phase shift signal used for phase adjustment on the reference clock signal and adding up the accumulated phase shift signals according to the count value, so as to obtain the phase of the clock signal to be measured.

In an embodiment, a maximum count value may be set for the counter. When a current count value of the counter reaches the maximum count value, that is, the number of times of phase adjustment performed by the signal processing assembly on the reference clock signal reaches a preset maximum number of times, the controller may reset the counter to 0, which indicates that the phase measurement is completed, and a next phase detection will be performed.

In an embodiment, the operation of obtaining, by the controller according to the cumulative phase value and the initial phase, the phase of the clock signal to be measured in S430 includes the following sub-steps.

At S431, the controller obtains, using the following formula and according to the cumulative phase value and the initial phase, the phase of the clock signal to be measured:

$$T1 = \left(T2 + \frac{1}{2}T\right) + \sum_{k=1}^{n}\left(\pm\frac{1}{2^{k+1}}T\right)$$

where T1 is the phase of the clock signal to be measured; T2 is the initial phase; $\sum_{k=1}^{n}\left(\pm\frac{1}{2^{k+1}}T\right)$ is the cumulative phase value; T is the period of the reference clock signal; and n is the number of times of phase adjustment performed on the reference clock signal, and n≥1.

In an embodiment, it can be learned from the foregoing formula that $\frac{1}{2^{k+1}}T$ determines accuracy of phase detection. When phase detection is performed, by using the phase detection method of this embodiment, on the clock signal to be measured, relatively accurate measurement can be achieved by performing phase shifting on the reference clock signal only a limited number of times. For example, during phase detection of a timestamp clock signal with a frequency of 125 MHz, a detection result with measurement accuracy of about 8 ps can be obtained by performing phase adjustment on the reference clock signal only 9 times. However, if the measurement is performed in a manner of obtaining phase information over one clock period in some cases, to achieve the same measurement accuracy, phase information is obtained by operations over one clock period with a step size of 8 ps, phase shifting needs to be performed 1000 times. Therefore, compared with such cases, this embodiment has a higher phase detection speed. In addition, it can be learned from the analysis that in a case of performing the same number of phase shifts, this embodiment has better phase detection accuracy compared with the above-described cases.

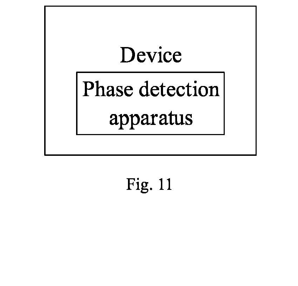

An embodiment of the present disclosure, as referring to Fig. 11, also provides a device which includes the phase detection apparatus in any one of the apparatus embodiments described above.

As the device in this embodiment includes the phase detection apparatus in any one of the foregoing embodiments, the device in this embodiment has a hardware structure of the phase detection apparatus in the foregoing embodiment. The components in the phase detection apparatus can collaborate with each other so that the device of this embodiment can perform the phase detection method in any of the foregoing method embodiments. Therefore, for detailed implementations of the device of this embodiment, reference may be made to the foregoing embodiment and details will not be repeated herein to avoid redundancy.

As the device in this embodiment has the phase detection apparatus in any one of the foregoing embodiments, the device in this embodiment has the technical effects brought by the phase detection apparatus in the foregoing embodiment. In other words, compared with some cases, the device in this embodiment can improve accuracy and speed of phase detection on a clock signal.

Embodiments of the present disclosure provide a phase detection method apparatus, and a device, and can improve accuracy and speed of phase detection on a clock signal.

In the embodiments of the present disclosure, a phase of a reference clock signal can approach a phase of a clock signal to be measured through a limited number of times of processing, so that measurement on a clock phase can be completed with high accuracy and high speed.

It can be understood by those having ordinary skill in the art that all or some of the steps of the methods and systems disclosed above can be implemented as software, firmware, hardware, and appropriate combinations thereof. Some or all of the physical components may be implemented as software executed by a processor, such as a central processing unit, a digital signal processor or a microprocessor, or as hardware, or as an integrated circuit, such as an applicationspecific integrated circuit. Such software can be distributed on computer-readable media, which can include computer-readable storage media (or non-transitory media) and communication media (or transitory media). As well known to those having ordinary skill in the art, the term computer-readable storage medium includes volatile and nonvolatile, removable and non-removable media implemented in any method or technique for storing information, such as computer-readable instructions, data structures, program modules or other data. A computer storage medium includes but is not limited to RAM, ROM, EEPROM, flash memory or other memory technologies, CD-ROM, digital versatile disk (DVD) or other optical disk storage, cassettes, magnetic tapes, magnetic disk storage or other magnetic storage devices, or any other medium that can be configured to store desired information and can be accessed by a computer. Furthermore, it is well known to those having ordinary skill in the art that communication media typically contain computer-readable instructions, data structures, program modules or other data in a modulated data signal such as a carrier wave or other transmission mechanism, and can include any information transmission media.

The above is a detailed description of some implementations of the present disclosure, but the present disclosure is not limited to the above-mentioned embodiments. Those having ordinary skill in the art can also make various equivalent modifications or replacements without departing from the scope of the present disclosure, and these equivalent modifications or replacements all shall fall within the scope defined by the appended claims of the present disclosure.

## Claims

1. A phase detection apparatus, comprising:

   a signal processing assembly configured to: acquire a reference clock signal and an initial phase of the reference clock signal, and output the reference clock signal;
   a phase discrimination component connected to the signal processing assembly, and configured to: acquire a clock signal to be measured, and obtain and output a first phase difference signal according to the reference clock signal and the clock signal to be measured; and
   a phase comparison assembly connected to each of the phase discrimination component and the signal processing assembly, and configured to: obtain and output a phase adjustment signal according to the first phase difference signal, wherein

the signal processing assembly is configured to: perform phase adjustment on the reference clock signal according to the phase adjustment signal so as to reduce the first phase difference signal, add up adjusted phase values to obtain a cumulative phase value, and obtain, according to the cumulative phase value and the initial phase, a phase of the clock signal to be measured.

2. The phase detection apparatus of claim 1, wherein the phase comparison assembly comprises:

a first signal generation component connected to the phase discrimination component and configured to obtain and output a first voltage signal according to the first phase difference signal; and

a signal comparison component connected to each of the first signal generation component and the signal processing assembly, and configured to: acquire a reference voltage signal and the first voltage signal, and obtain and output the phase adjustment signal according to the reference voltage signal and the first voltage signal.

3. The phase detection apparatus of claim 2, wherein the phase comparison assembly comprises:
a second signal generation component connected to the signal comparison component, and configured to: acquire a phase reference signal, and obtain and output the reference voltage signal according to the phase reference signal, wherein the phase reference signal is obtained according to the reference clock signal.

4. The phase detection apparatus of any one of claims 1 to 3, wherein the signal processing assembly comprises:

a controller connected to the phase comparison assembly, and configured to: acquire the initial phase of the reference clock signal, and obtain and output a phase shift signal according to the phase adjustment signal; and

a phase shift component connected to each of the controller and the phase discrimination component, and configured to: acquire the reference clock signal, and perform phase adjustment on the reference clock signal according to the phase shift signal so as to reduce the first phase difference signal, wherein

the controller is configured to add up the phase shift signals to obtain a cumulative phase value, and obtain, according to the cumulative phase value and the initial phase, the phase of the clock signal to be measured.

5. The phase detection apparatus of claim 4, wherein the signal processing assembly comprises:
a counter, which is built in the controller, or which is disposed outside the controller and connected to the controller.

6. The phase detection apparatus of claim 4, wherein the controller is configured to obtain, by using the following formula and according to the cumulative phase value and the initial phase, the phase of the clock signal to be measured,

$$T1 = \left( T2 + \frac{1}{2}T \right) + \sum_{k=1}^{n} \left( \pm \frac{1}{2^{k+1}}T \right)$$

where T1 is the phase of the clock signal to be measured; T2 is the initial phase; $\sum_{k=1}^{n} \left( \pm \frac{1}{2^{k+1}}T \right)$ is the cumulative phase value; T is a period of the reference clock signal; and n is a number of times of phase adjustment performed on the reference clock signal, and n≥1.

7. A phase detection method which is applied to a phase detection apparatus, wherein the phase detection apparatus comprises a signal processing assembly, a phase discrimination component and a phase comparison assembly serially connected in a loop;
the method comprising:

acquiring, by the signal processing assembly, a reference clock signal and an initial phase of the reference clock signal, and outputting the reference clock signal to the phase discrimination component;
acquiring, by the phase discrimination component, a clock signal to be measured, obtaining a first phase difference signal according to the reference clock signal and the clock signal to be measured, and outputting the first phase difference signal to the phase comparison assembly;
obtaining, by the phase comparison assembly, a phase adjustment signal according to the first phase difference signal, and outputting the phase adjustment signal to the signal processing assembly; and
performing, by the signal processing assembly, phase adjustment on the reference clock signal according to the phase adjustment signal so as to reduce the first phase difference signal, adding up adjusted phase values to obtain a cumulative phase value, and obtaining, according to the cumulative phase value and the initial phase, a phase of the clock signal to be measured.

8.  The method of claim 7, wherein:

    the phase comparison assembly comprises a first signal generation component and a signal comparison component, and the signal processing assembly, the phase discrimination component, the first signal generation component and the signal comparison component are serially connected in a loop; and
    obtaining, by the phase comparison assembly, a phase adjustment signal according to the first phase difference signal, and outputting the phase adjustment signal to the signal processing assembly comprises:

        obtaining, by the first signal generation component, a first voltage signal according to the first phase difference signal, and outputting the first voltage signal to the signal comparison component; and
        acquiring, by the signal comparison component, a reference voltage signal and the first voltage signal, obtaining the phase adjustment signal according to the reference voltage signal and the first voltage signal, and outputting the phase adjustment signal to the signal processing assembly.

9.  The method of claim 8, wherein obtaining, by the signal comparison component, the phase adjustment signal according to the reference voltage signal and the first voltage signal comprises at least one of:

        in response to the first voltage signal being larger than the reference voltage signal, outputting, by the signal comparison component, a phase adjustment signal with a level value of a high level;
        in response to the first voltage signal being equal to the reference voltage signal, outputting, by the signal comparison component, a phase adjustment signal with a level value of a medium level, wherein the medium level is a level between the high level and a low level; or
        in response to the first voltage signal being less than the reference voltage signal, outputting, by the signal comparison component, a phase adjustment signal with a level value of the low level.

10. The method of claim 8, wherein:

the phase comparison assembly comprises a second signal generation component, the second signal generation component being connected to the signal comparison component; and
the method further comprises:

    acquiring, by the second signal generation component, a phase reference signal, and obtaining the reference voltage signal according to the phase reference signal, wherein the phase reference signal is obtained according to the reference clock signal; and
    outputting, by the second signal generation component, the reference voltage signal to the signal comparison component.

11. The method of claim 7, wherein performing, by the signal processing assembly, phase adjustment on the reference clock signal according to the phase adjustment signal comprises at least one of:

    in response to a level value of the phase adjustment signal being a high level, performing, by the signal processing assembly, a negative phase shift on the reference clock signal;
    in response to a level value of the phase adjustment signal being a low level, performing, by the signal processing assembly, a positive phase shift on the reference clock signal; or
    in response to a level value of the phase adjustment signal being a medium level, skipping, by the signal processing assembly, phase adjustment on the reference clock signal, wherein the medium level is a level between the high level and the low level.

12. The method of any one of claims 7 to 11, wherein:

    the signal processing assembly comprises a controller and a phase shift component, and the phase comparison assembly, the controller, the phase shift component and the phase discrimination component are serially connected in a loop; and
    performing, by the signal processing assembly, phase adjustment on the reference clock signal according to the phase adjustment signal so as to reduce the first phase difference signal, adding up the adjusted phase values to obtain a cumulative phase value, and obtaining, according to the cumulative phase value and the initial phase, a phase of the clock signal to be measured comprises:

        obtaining, by the controller, a phase shift signal according to the phase adjustment signal, and outputting the phase shift signal to the phase shift component;

performing, by the phase shift component, phase adjustment on the reference clock signal according to the phase shift signal so as to reduce the first phase difference signal; and

adding up, by the controller, the phase shift signals, to obtain a cumulative phase value; and obtaining, according to the cumulative phase value and the initial phase, the phase of the clock signal to be measured.

13. The method of claim 12, wherein:

the signal processing assembly comprises a counter which is built in the controller or which is disposed outside the controller and connected to the controller; and

obtaining, by the controller, a phase shift signal according to the phase adjustment signal comprises:

acquiring, by the controller, a count value from the counter; and

obtaining, by the controller, the phase shift signal according to the count value.

14. The method of claim 12, wherein obtaining, by the controller according to the cumulative phase value and the initial phase, the phase of the clock signal to be measured comprises:

obtaining, by the controller using the following formula and according to the cumulative phase value and the initial phase, the phase of the clock signal to be measured,

$$T1 = \left(T2 + \frac{1}{2}T\right) + \sum_{k=1}^{n}\left(\pm\frac{1}{2^{k+1}}T\right)$$

where T1 is the phase of the clock signal to be measured; T2 is the initial phase; $\sum_{k=1}^{n}\left(\pm\frac{1}{2^{k+1}}T\right)$ is the cumulative phase value; T is a period of the reference clock signal; and n is a number of times of phase adjustment performed on the reference clock signal, and n≥1.

15. A device comprising the phase detection apparatus of any one of claims 1 to 6.

120

100

Clock
signal to be
measured

First phase
difference signal

Phase detection
apparatus

Phase
discrimination
component

Phase comparison
assembly

130

Reference
clock signal

Phase
adjustment
signal

Signal processing
assembly

Reference clock
signal

110

Fig. 1

120

131

100

130

Clock signal
to be
measured

First phase
difference
signal

First voltage
signal

132

Phase
discrimination
component

First signal
generation
component

Signal
comparison
component

Reference
clock signal

Phase adjustment
signal

Signal processing
assembly

Reference clock signal

110

Fig. 2

100

133

120

Phase reference
signal

Second
signal
generation
component

Reference voltage signal

130

Clock
signal to be
measured

First phase
difference
signal

First voltage
signal

132

Phase
discrimination
component

First signal
generation
component

Signal
comparison
component

Reference
clock signal

131

Phase adjustment signal

Signal processing
assembly

Reference clock signal

110

Fig. 3

100

133

120

Phase reference
signal

Second
signal
generation
component

Reference voltage signal

130

Clock
signal to be
measured

First phase
difference
signal

First voltage
signal

132

Phase
discrimination
component

First signal
generation
component

Signal
comparison
component

Reference clock
signal after phase
shift

131

Phase shift signal

Phase
adjustment
signal

Phase shift
component

Controller

Reference clock signal

112

110

111

Fig. 4

233

200

Phase reference
signal

220

Second
charge
pump

Reference voltage signal

232

Clock
signal to be
measured

First phase
difference
signal

First voltage
signal

Voltage
comparator

Digital phase
discriminator

First charge
pump

Reference clock
signal after
phase shift

231

Phase
adjustment
signal

213

Phase shift signal

Digital
phase
shifter

Controller

Counter

Reference clock
signal

212

211

Fig. 5

A signal processing assembly acquires a reference clock signal and an initial phase of the reference clock signal, and outputs the reference clock signal to a phase discrimination component — S100

The phase discrimination component acquires a clock signal to be measured, obtains a first phase difference signal according to the reference clock signal and the clock signal to be measured, and outputs the first phase difference signal to a phase comparison assembly — S200

The phase comparison assembly obtains a phase adjustment signal according to the first phase difference signal, and outputs the phase adjustment signal to the signal processing assembly — S300

The signal processing assembly performs phase adjustment on the reference clock signal according to the phase adjustment signal so as to reduce the first phase difference signal, adds up the adjusted phase values so as to obtain a cumulative phase value, and obtains, according to the cumulative phase value and the initial phase, a phase of the clock signal to be measured — S400

Fig. 6

A first signal generation component obtains a first voltage signal according to a first phase difference signal, and outputs the first voltage signal to a signal comparison component — S310

The signal comparison component acquires a reference voltage signal and the first voltage signal, obtains a phase adjustment signal according to the reference voltage signal and the first voltage signal, and outputs the phase adjustment signal to a signal processing assembly — S320

Fig. 7

A second signal generation component acquires a phase reference signal, and obtains a reference voltage signal according to the phase reference signal, where the phase reference signal is obtained according to a reference clock signal

S500

The second signal generation component outputs the reference voltage signal to a signal comparison component

S600

Fig. 8

A controller obtains a phase shift signal according to a phase adjustment signal, and outputs the phase shift signal to a phase shift component

S410

The phase shift component performs phase adjustment on a reference clock signal according to the phase shift signal so as to reduce a first phase difference signal

S420

The controller adds up the phase shift signals so as to obtain a cumulative phase value, and obtains, according to the cumulative phase value and an initial phase, a phase of a clock signal to be measured

S430

Fig. 9

A controller acquires a count value from a counter

S411

The controller obtains a phase shift signal according to the count value

S412

Fig. 10

Device

Phase detection
apparatus

Fig. 11

## INTERNATIONAL SEARCH REPORT

| International application No. |
| --- |
| **PCT/CN2021/093649** |

**A.    CLASSIFICATION OF SUBJECT MATTER**

H03L 7/08(2006.01)i;  H03L 7/097(2006.01)i

According to International Patent Classification (IPC) or to both national classification and IPC

**B.    FIELDS SEARCHED**

Minimum documentation searched (classification system followed by classification symbols)

H03L

Documentation searched other than minimum documentation to the extent that such documents are included in the fields searched

Electronic data base consulted during the international search (name of data base and, where practicable, search terms used)

WPI, EPODOC, CNPAT, CNKI, IEEE: 相位, 检测, 监测, 信号处理, 参考时钟信号, 初始相位值, 鉴相部件, 相位差, 相位调整, 累计, 累加, 相加, phase, detect, monitor, reference clock signal, reference signal, initial phase value, phase difference, adjust, adding, plus

**C.    DOCUMENTS CONSIDERED TO BE RELEVANT**

| Category* | Citation of document, with indication, where appropriate, of the relevant passages | Relevant to claim No. |
| --- | --- | --- |
| A | CN 108599760 A (NEWCOSEMI (BEIJING) TECHNOLOGY CO., LTD.) 28 September 2018 (2018-09-28)<br>description, paragraphs 0028-0047, figures 2-4 | 1-15 |
| A | CN 1464637 A (HUAWEI TECHNOLOGIES CO., LTD.) 31 December 2003 (2003-12-31)<br>entire document | 1-15 |
| A | CN 1359195 A (VIA TECHNOLOGIES, INC.) 17 July 2002 (2002-07-17)<br>entire document | 1-15 |
| A | CN 104280613 A (CHENGDU CORPRO TECHNOLOGY CO., LTD.) 14 January 2015 (2015-01-14)<br>entire document | 1-15 |
| A | CN 101079630 A (ZTE CORPORATION) 28 November 2007 (2007-11-28)<br>entire document | 1-15 |
| A | CN 106603449 A (CENTRON COMMUNICATIONS TECHNOLOGIES FUJIAN CO., LTD.) 26 April 2017 (2017-04-26) | 1-15 |

☑ Further documents are listed in the continuation of Box C.     ☑ See patent family annex.

| | |
| --- | --- |
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **30 July 2021** | **12 August 2021** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2021/093649**

| C. | DOCUMENTS CONSIDERED TO BE RELEVANT | | |
|---|---|---|
| Category* | Citation of document, with indication, where appropriate, of the relevant passages | Relevant to claim No. |
| A | CN 101207436 A (SHANGHAI HUAWEI TECHNOLOGIES CO., LTD.) 25 June 2008 (2008-06-25)<br>entire document | 1-15 |
| A | US 4965533 A (QUALCOMM INCORPORATED) 23 October 1990 (1990-10-23)<br>entire document | 1-15 |

Form PCT/ISA/210 (second sheet) (January 2015)

**INTERNATIONAL SEARCH REPORT**
Information on patent family members

International application No.

**PCT/CN2021/093649**

| Patent document cited in search report | | | Publication date (day/month/year) | Patent family member(s) | | | Publication date (day/month/year) |
|---|---|---|---|---|---|---|---|
| CN | 108599760 | A | 28 September 2018 | CN | 208337544 | U | 04 January 2019 |
| CN | 1464637 | A | 31 December 2003 | None | | | |
| CN | 1359195 | A | 17 July 2002 | CN | 1159848 | C | 28 July 2004 |
| CN | 104280613 | A | 14 January 2015 | CN | 104280613 | B | 08 March 2017 |
| CN | 101079630 | A | 28 November 2007 | CN | 101079630 | B | 12 May 2010 |
| CN | 106603449 | A | 26 April 2017 | None | | | |
| CN | 101207436 | A | 25 June 2008 | CN | 101207436 | B | 15 August 2012 |
| US | 4965533 | A | 23 October 1990 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010428524